# EUROPÄISCHE PATENTSCHRIFT

(11) **EP 4 000 360 B1**
(45) Veröffentlichungstag und Bekanntmachung des Hinweises auf die Patenterteilung: **06.08.2025**
(21) Anmeldenummer: 20733793.2
(22) Anmeldetag: 18.06.2020
(51) Int. Cl.: H05K 7/14, H05K 9/00

(54) **FELDGERÄT DER AUTOMATISIERUNGSTECHNIK**
AUTOMATION FIELD DEVICE
APPAREIL DE TERRAIN DU DOMAINE DE LA TECHNIQUE D'AUTOMATISATION

(30) Priorität: 17.07.2019 DE 102019119426
(43) Veröffentlichungstag der Anmeldung: 25.05.2022
(73) Patentinhaber: Endress+Hauser SE+Co. KG, 79689 Maulburg (DE)
(72) Erfinder: STRITTMATTER, Christian, 79736 Rickenbach (DE); GERWIG, Simon, 79650 Schopfheim (DE); FUZ, Andreas, 79588 Efringen-Kirchen (DE)
(74) Vertreter: Endress + Hauser Group Services (Deutschland) AG+Co. KG
(86) Internationale Anmeldenummer: PCT/EP2020/066981
(87) Internationale Veröffentlichungsnummer: WO 2021/008809

(56) Entgegenhaltungen:
- EP-B1- 2 791 631
- CN-A- 107 727 301
- CN-A- 107 727 309
- CN-A- 109 425 378
- DE-A1- 102014 221 368
- US-A- 5 672 844
- US-A1- 2006 055 006
- US-A1- 2006 164 203
- US-A1- 2018 160 574

## Beschreibung

Die Erfindung bezieht sich auf eine Feldgerät der Automatisierungstechnik. Aus dem Stand der Technik sind Feldgeräte bekannt, die in industriellen Anlagen zum Einsatz kommen. In der Prozessautomatisierungstechnik ebenso wie in der Fertigungsautomatisierungstechnik werden vielfach Feldgeräte eingesetzt. Als Feldgeräte werden im Prinzip alle Geräte bezeichnet, die prozessnah eingesetzt werden und die prozessrelevante Informationen liefern oder verarbeiten. So werden Feldgeräte zur Erfassung und/oder Beeinflussung von Prozessgrößen verwendet. Zur Erfassung von Prozessgrößen dienen Messgeräte, bzw. Sensoren. Diese werden beispielsweise zur Druck- und Temperaturmessung, Leitfähigkeitsmessung, Durchflussmessung, etc. verwendet und erfassen die entsprechenden Prozessvariablen Druck, Temperatur, Leitfähigkeit, pH-Wert, Füllstand, Durchfluss etc. Zur Beeinflussung von Prozessgrößen werden Aktoren verwendet. Diese sind beispielsweise Pumpen oder Ventile, die den Durchfluss einer Flüssigkeit in einem Rohr oder den Füllstand in einem Behälter beeinflussen können. Neben den zuvor genannten Messgeräten und Aktoren werden unter Feldgeräten auch Remote I/Os, Funkadapter bzw. allgemein Geräte verstanden, die auf der Feldebene angeordnet sind.

US 2018/160574 A1, CN 109 425 378 A, US 2006/055006 A1, US 2006/164203 A1 und US 5 672 844 A sind verwandte Referenzen des Standes der Technik.

Eine Vielzahl solcher Feldgeräte wird von der Endress+Hauser-Gruppe produziert und vertrieben.

Üblicherweise werden die Gehäuse der Feldgeräte aus einem elektrisch leitenden Material, insbesondere aus Metall gefertigt. Hierbei kann eine Erdung der im Gehäuse befindlichen Feldgeräteelektronik über eine Gehäusewandung erfolgen. Üblicherweise wird die Erdverbindung mit Hilfe von Schrauben und/oder Klemmungen abgeleitet. Dies setzt einen metallisierten Bereich auf einer Leiterplatte (Kantenmetallisierung) oder einen Erdungsbügel voraus. Beide Varianten sind in der Fertigung des Feldgerätes relativ aufwendig zu realisieren.

Ausgehend davon ist es nunmehr Aufgabe der vorliegenden Erfindung eine möglichst einfache Erdung einer Feldgeräteelektronik in einem Felsgerätegehäuse vorzuschlagen.

Die Aufgabe wird erfindungsgemäß durch das Feldgerät der Automatisierungstechnik gelöst, welches die Merkmale gemäß Patentanspruch 1 umfasst.

Erfindungsgemäß wird ein Feldgerät der Automatisierungstechnik vorgeschlagen, bei dem die Erdung über Federkontakte bzw. Federkontakte realisiert wird. Dies bietet den Vorteil, dass keine Schraub-/Klemmverbindung erforderlich ist und somit ein Arbeitsschritt bei der Fertigung des Feldgerätes entfallen kann. Ein weiterer Vorteil gegenüber einer geklemmten/geschraubten Variante besteht darin, dass die Leiterplatte kostengünstiger gefertigt werden kann, da keine Kantenmetallisierungen mehr notwendig sind. Weitere Vorteile bestehen darin, dass Toleranzen im Gehäuse oder der Leiterplatte über den Federweg der Federkontakte ausgeglichen werden können und/oder dass bei Vibrationen des Feldgerätes kaum Reibung auf den Kontaktflächen entsteht, da die Federn den Großteil der Vibration über den Federweg ausgleichen können.

Eine vorteilhafte Ausgestaltung des erfindungsgemäßen Feldgeräts der Automatisierungstechnik sieht vor, dass die Federkontakte im Wesentlichen rotationssymmetrische in dem Randbereich auf der ersten Leiterplatte angeordnet sind.

Eine weitere vorteilhafte Ausgestaltung des erfindungsgemäßen Feldgeräts der Automatisierungstechnik sieht vor, dass die elektronische Schaltung zumindest eine weitere Leiterplatten umfasst, die elektrisch mit der ersten Leiterplatte verbunden ist, und wobei die erste Leiterplatte (5a) ferner elektronische Bauteile umfasst, die dazu ausgebildet sind, EMV Maßnahmen, insbesondere EMV Filtermaßnahmen und/oder EMV Ableitmaßnahmen, zu realisieren.

Wiederum ein weitere vorteilhafte Ausgestaltung des erfindungsgemäßen Feldgeräts der Automatisierungstechnik sieht vor, dass die erste Leiterplatte aus mehreren Lagen ausgebildet ist, wovon zumindest eine Lage eine im Wesentlichen durchgezogene Kupferlage umfasst, sodass die erste Leiterplatte den Innenraum in einen EMV abgeschirmten und einen nicht abgeschirmten EMV Bereich unterteilt. Es versteht sich von selbst, dass trotz der zumindest einen durchgezogenen Kupferlage Durchkontaktierungen, z.B. in Form von Vias und/oder Mikrovias, in der Leiterplatte zur Durchkontaktierung vorhanden sein können und dass insbesondere die durchgezogene Kupferlage selbst auch Durchkontaktierungen aufweisen kann.

Eine weitere vorteilhafte Ausgestaltung des erfindungsgemäßen Feldgeräts der Automatisierungstechnik sieht vor, dass das Feldgerät ferner eine in das Gehäuse eingebrachte Feldgeräteschnittstelle, vorzugsweise einen Steckverbinder, besonders bevorzugt einen M12 Steckverbinder zur Datenkommunikation, umfasst, wobei die Feldgeräteschnittstelle ferner einen elektrischen Erdungskontakt aufweist, über den die erste Leiterplatte mit der Feldgeräteschnittstelle verbunden ist, um die Störströme abzuleiten.

Die Erfindung wird anhand der nachfolgenden Zeichnungen näher erläutert. Es zeigt:
Fig. 1a: eine Draufsicht auf eine erste Leiterplatte für eine elektronische Schaltung eines Feldgerätes,
Fig. 1b: eine Seitenansicht der in Fig. 1 dargestellten ersten Leiterplatte für eine elektronische Schaltung eines Feldgerätes, und
Fig. 2: einen Querschnitt durch ein erfindungsgemäßes Feldgerät der Automatisierungstechnik.

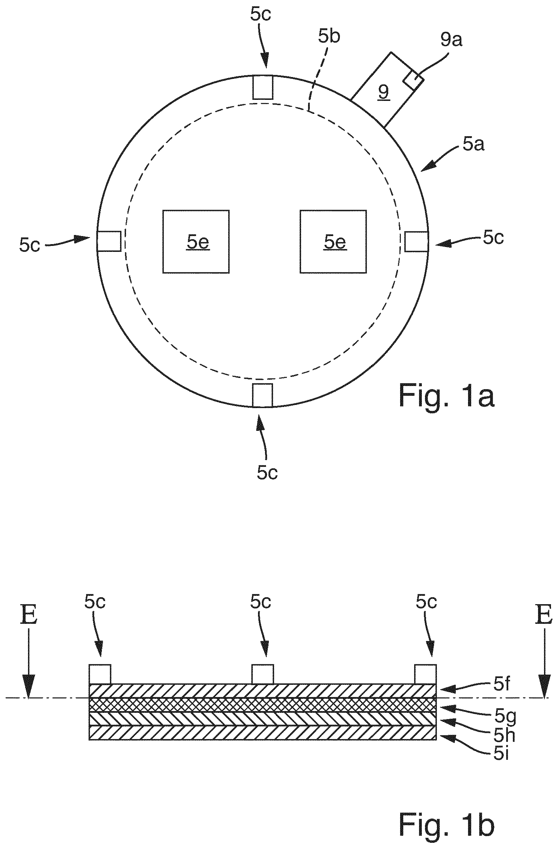

Figur 1a zeigt eine Draufsicht auf die erste Leiterplatte 5a, die als ein Teil einer elektronischen Schaltung 5 für ein Feldgerät 1 der Automatisierungstechnik dient. Die erste Leiterplatte 5a ist dazu ausgebildet, EMV Maßnahmen, insbesondere EMV Filtermaßnahmen und/oder EMV Ableitmaßnahmen zu realisieren. Hierzu kann die erste Leiterplatte 5a ein EMV-Filter aufweisen, welches beispielweise aus zwei EMV Drosseln ausgebildet ist. Die erste Leiterplatte 5a weist eine runde Außenkontur auf, die derartig auf einen Innenraum 3 eines Gehäuses 2 eines Feldgerätes 1 abgestimmt ist, dass die erste Leiterplatte 5a quer in den Innenraum 3 einführbar ist. Ferner weist die erste Leiterplatte 5a mehrere in einem Randbereich 5b rotationssymmetrisch angeordnete Federkontakte 5c auf. Die Federkontakte 5c sind dabei derartig ausgebildet, dass sie einen (rechtwinkligen) trapezförmigen Querschnitt aufweisen. Die Federkontakte 5c sind derartig in dem Randbereich 5b der ersten Leiterplatte 5a angeordnet, dass diese mit den nach außen hin gebogenen Schenkeln über den Leiterplattenrand hinausstehen. Hierdurch kann zum einen die erste Leiterplatte 5a, nachdem sie in den Innenraum 3 des Gehäuses 2 eingeführt ist, in diesem positioniert werden und zum anderen können Störsignal über die Federkontakte 5c zur Gehäusewand abgeleitet werden. Durch die rotationssymmetrische Anordnung der Federkontakte 5c können die Störströme relativ gleichmäßig über die Gehäusewand abgeleitet werden.

Um durch die erste Leiterplatte 5a eine Trennung zwischen einem EMV abgeschirmten ("Faraday'scher Käfig") und einem nicht abgeschirmten EMV Bereich realisieren zu können, kann die erste Leiterplatte 5a mehrere Leiterplattenlagen 5f-5i aufweisen, wovon zumindest eine Leiterplattenlage in Form einer durchgezogenen Kupferleiterplattenlage 5g ausgebildet ist. Ferner kann die erste Leiterplatte 5a Vias und/oder Mikrovias zur elektrischen Durchkontaktierung aufweisen.

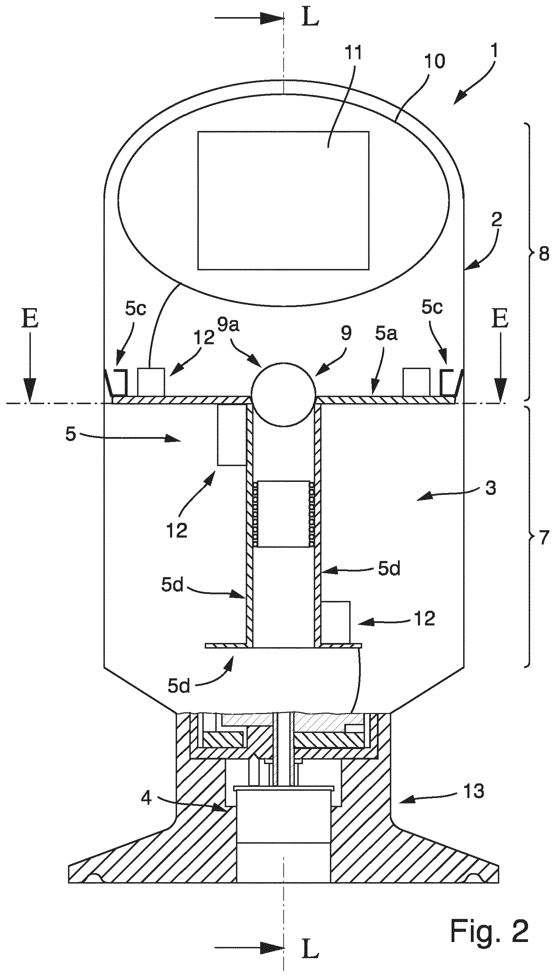

Figur 2 zeigt ein erfindungsgemäßes Feldgerät der Automatisierungstechnik 1, welches ein Gehäuse 2, welches einen Innenraum 3 umschließt, der im Querschnitt eine runde Innenkontur aufweist, umfasst. Das Feldgerät 1 umfasst ferner ein an dem Gehäuse 2 angeordnetes Sensor- und/oder Aktorelement 4 zum Stellen und/oder Erfassen einer Prozessgröße sowie eine in dem Innenraum 3 eingebrachte elektronische Schaltung 5, die dazu ausgebildet ist, das Sensor- und/oder Aktorelement 4 zu betreiben. Erfindungsgemäß umfasst die elektronische Schaltung 5 eine erste Leiterplatte 5a, die wie zuvor beschrieben ausgebildet sein kann. Die erste Leiterplatte 5a ist mit einer Hauptebene, wie sie in Fig. 1b und 2 symbolisch durch eine mit "E" gekennzeichnet Linie dargestellt ist, orthogonal zu einer Längsachse in den Innenraum eingebracht. Die Längsachse ist in Fig. 2 symbolisch durch eine mit "L" gekennzeichnete Linie dargestellt. Durch die im Randbereich 5b angeordneten und mit den nach außen hin gebogenen Schenkeln der Federkontakte 5c wird die erste Leiterplatte 5a in dem Innenraum 3 gehalten und ferner werden Störströme von der ersten Leiterplatte 5a zu dem Gehäuse 2 abgeleitet. Ferner wird durch die orthogonale Ausrichtung der ersten Leiterplatte 5a zu der Längsachse des Innenraums des Gehäuses 2 in zwei Bereich bzw. Kammern unterteilt. Einen ersten nicht EMV abgeschirmten Bereich und einen EMV abgeschirmten Bereich. Der nicht EMV abgeschirmte Bereich befindet sich dabei vorzugsweise im oberen Teil des Feldgerätes 1. In diesem Teil des Feldgerätes 1 weist das Gehäuse 2 ferner einen Deckel auf, in bzw. an dem ein Display 11 angebracht ist. Das Display 11 ist über eine Leiterplatte 10 zur Displayansteuerung mit der elektronischen Schaltung 5 elektrisch verbunden, bspw. über eine Steckverbindung 12.

Das Feldgerät 1 umfasst weiterhin eine Feldgeräteschnittstelle 9 über die die elektronische Schaltung 5 des Feldgerätes 1 je nach Ausgestaltung entweder an eine Zwei-, Drei oder Vierdrahtleitung angebunden wird, umso Daten, insbesondere Mess- und/oder Stellwert, zwischen der elektrischen Schaltung und einer übergeordneten Einheit zu kommunizieren. Die Feldgeräteschnittstelle 9 kann beispielsweise in Form eines Steckverbinders, beispielsweise einer M12-Steckverbinderschnittstelle ausgebildet sein. Ferner kann die Feldgeräteschnittstelle 9 eine elektrischen Erdungskontakt 9a aufweisen, über den die erste Leiterplatte 5a mit der Feldgeräteschnittstelle 9 verbunden ist, um die Störströme abzuleiten. Der Erdungskontakt 9a kann als ein Teil der Feldgeräteschnittstelle 9 ausgebildet sein. Alternativ kann die Erdung auch über das Gehäuse 2 und einen Prozessanschluss 13 erfolgen, über den das Feldgerät 1 beispielsweise an einem Tank bzw. Behälter befestigt ist.

Die elektronische Schaltung 5 kann, wie in Fig. 2 dargestellt, durch mehrere weitere Leiterplatten 5d gebildet sein, wobei die Leiterplatten 5a, 5d über Steckverbindungen 12 ineinandergesteckt und somit elektrisch kontaktiert sind. Um einen möglichst platzsparenden Aufbau zu erzielen, können die Leiterplatten 5a, 5d zueinander gekippt bzw. verdreht sein. Beispielsweise können, wie in Fig. 2 dargestellt, von der ersten Leiterplatter 5a zwei weitere Leiterplatten 5d orthogonal abgehen, an denen wiederum, an einem von der ersten Leiterplatte 5a abgewandten Ende, eine weitere Leiterplatte 5d angebracht ist.

### Bezugszeichenliste

- 1: Feldgerät der Automatisierungstechnik
- 2: Gehäuse
- 3: Innenraum
- 4: Sensor- und/oder Aktorelement
- 5: Elektronische Schaltung
- 5a: Erste Leiterplatte
- 5b: Randbereich der ersten Leiterplatte
- 5c: Federkontakte
- 5d: Weitere Leiterplatten
- 5e: Elektronische Bauteile für EMV Maßnahmen
- 5f- 5i: Leiterplattenlagen
- 5g: Kupferleiterplattenlage
- 7: EMV abgeschirmter Bereich
- 8: Nicht abgeschirmter EMV Bereich
- 9: Feldgeräteschnittstelle, insb. M12-Schnittstelle
- 9a: Elektrischer Erdungskontakt der Feldgeräteschnittstelle
- 10: Leiterplatte für Displayansteuerung
- 11: Display
- 12: Elektrische Steckverbindung
- 13: Prozessanschluss
- E: Ebene in der die erste Leiterplatte ausgebildet ist
- L: Längsachse die sich durch den Innenraum des Gehäuses erstreckt

## Patentansprüche

1. Feldgerät der Automatisierungstechnik (1), aufweisend:
- ein Gehäuse (2), welches einen Innenraum (3) umschließt, der im Querschnitt eine runde Innenkontur aufweist;
- ein am Gehäuse (2) angeordnetes Sensor- und/oder Aktorelement (4) zum Stellen und/oder Erfassen einer Prozessgröße;
- eine in dem Gehäuse (2) angeordnete elektronische Schaltung (5) zum Betreiben des Sensor- und/oder Aktorelements (4), wobei die elektronische Schaltung (5) zumindest eine Leiterplatte (5a) mit einer runden Außenkontur und in einem Randbereich (5b) mehrere Federkontakte (5c) aufweist, wobei die Innenkontur des Gehäuses und die Randkontur der ersten Leiterplatte (5a) so aufeinander abgestimmt sind, dass die erste Leiterplatte (5a) mit einer Hauptebene (E), in der sie ausgebildet ist, orthogonal zu einer Längsachse (L), die sich durch den Innenraum (3) des Gehäuses (2) erstreckt, in das Gehäuse (2) eingeführt ist ohne dass die Außenkontur der ersten Leiterplatte (5a) die Innenkontur des Innenraums berührt und die Federkontakte (5c) so auf der ersten Leiterplatte (5a) angeordnet sind, dass diese mit nach außen hin gebogenen Schenkeln über einen Leiterplattenrand der ersten Leiterplatte hinausstehen und die Federkontakte ferner dazu ausgestaltet sind, zumindest die erste Leiterplatte (5a) in dieser Position in dem Innenraum (3) zu halten und ferner eine elektrische Verbindung zwischen der ersten Leiterplatte (5a) und dem Gehäuse (2) herzustellen, um Störströme von der ersten Leiterplatte (5a) über die Federkontakte (5c) zum Gehäuse (2) zu führen.

2. Feldgerät nach Anspruch 1, wobei die Federkontakte (5c) im Wesentlichen rotationssymmetrische in dem Randbereich (5b) auf der ersten Leiterplatte (5a) angeordnet sind.

3. Feldgerät nach einem der vorhergehenden Ansprüche, wobei die elektronische Schaltung (5) zumindest eine weitere Leiterplatten (5d) umfasst, die elektrisch mit der ersten Leiterplatte (5a) verbunden ist, und wobei die erste Leiterplatte (5a) ferner elektronische Bauteile (5e) umfasst, die dazu ausgebildet sind, EMV Maßnahmen, insbesondere EMV Filtermaßnahmen und/oder EMV Ableitmaßnahmen, zu realisieren.

4. Feldgerät nach einem der vorhergehenden Ansprüche, wobei die erste Leiterplatte (5a) aus mehreren Lagen (5f-5i) ausgebildet ist, wovon zumindest eine Lage eine im Wesentlichen durchgezogene Kupferlage (5g) umfasst, sodass die erste Leiterplatte (5a) den Innenraum (3) in einen EMV abgeschirmten (7) und einen nicht abgeschirmten EMV Bereich (8) unterteilt.

5. Feldgerät nach einem der vorhergehenden Ansprüche, ferner umfassend eine in das Gehäuse (2) eingebrachte Feldgeräteschnittstelle (9), vorzugsweise einen Steckverbinder, besonders bevorzugt einen M12 Steckverbinder zur Datenkommunikation, wobei die Feldgeräteschnittstelle (9) ferner einen elektrischen Erdungskontakt (9a) aufweist, über den die erste Leiterplatte (5a) mit der Feldgeräteschnittstelle (9) verbunden ist, um die Störströme abzuleiten.

## Claims

1. An automation technology field device (1), having:
- A housing (2), which surrounds an interior (3) that has a round inner contour in cross-section;
- A sensor and/or actuator element (4) arranged on the housing (2) for supplying and/or detecting a process variable;
- An electronic circuit (5) arranged in the housing (2) for operating the sensor and/or actuator element (4), wherein the electronic circuit (5) has at least one PCB (5a) with a round outer contour and multiple spring contacts (5c) in an edge area (5b), wherein the inner contour of the housing and the edge contour of the first PCB (5a) are adapted to each other in such a way that the first PCB (5a) with a main plane (E) in which it is formed is inserted into the housing (2) orthogonally relative to a longitudinal axis (L), which extends through the interior (3) of the housing (2), without the outer contour of the first PCB (5a) touching the inner contour of the interior, and wherein the spring contacts (5c) are arranged on the first PCB (5a) in such a way that their legs, which are bent outward, protrude beyond a PCB edge of the first PCB, and wherein the spring contacts are further configured to hold at least the first PCB (5a) in this position in the interior (3) and further to establish an electrical connection between the first PCB (5a) and the housing (2) in order to conduct parasitic currents from the first PCB (5a) via the spring contacts (5c) to the housing (2).

2. The field device as claimed in claim 1, wherein the spring contacts (5c) are arranged mostly rotationally symmetrical in the edge area (5b) on the first PCB (5a).

3. The field device as claimed in one of the preceding claims, wherein the electronic circuit (5) comprises at least one additional PCB (5d), which is electrically connected to the first PCB (5a), and wherein the first PCB (5a) further comprises electronic components (5e), which are configured to implement EMC measures, in particular EMC filter measures and/or EMC dissipation measures.

4. The field device as claimed in one of the preceding claims, wherein the first PCB (5a) is formed of multiple layers (5f-5i), of which at least one layer comprises a mainly drawn through copper layer (5g), so that the first PCB (5a) divides the interior (3) into one area with EMC shielding (7) and one area without EMC shielding (8).

5. The field device as claimed in one of the preceding claims, further comprising a field device interface (9) integrated into the housing (2), preferably a plug connector, particularly preferably an M12 plug connector for data communication, wherein the field device interface (9) further has an electrical grounding contact (9a) via which the first PCB (5a) is connected to the field device interface (9) in order to dissipate parasitic currents.

## Revendications

1. Appareil de terrain de la technique d'automatisation (1), lequel appareil comprend :
- un boîtier (2), lequel renferme un espace intérieur (3) dont la section transversale présente un contour intérieur rond ;
- un élément capteur et/ou actionneur (4) disposé sur le boîtier (2), lequel élément est destiné à régler et/ou à mesurer une grandeur de process ;
- un circuit électronique (5) disposé dans le boîtier (2), lequel circuit est destiné à faire fonctionner l'élément capteur et/ou actionneur (4), le circuit électronique (5) présentant au moins une carte de circuit imprimé (5a) avec un contour extérieur rond et plusieurs contacts à ressort (5c) dans une zone de bordure (5b), le contour intérieur du boîtier et le contour de bord de la première carte de circuit imprimé (5a) étant adaptés l'un à l'autre de telle sorte que la première carte de circuit imprimé (5a) est insérée dans le boîtier (2) - avec un plan principal (E) dans lequel elle est formée, lequel plan est orthogonal à un axe longitudinal (L) qui s'étend à travers l'espace intérieur (3) du boîtier (2) - sans que le contour extérieur de la première carte de circuit imprimé (5a) touche le contour intérieur de l'espace intérieur et les contacts à ressort (5c) sont disposés sur la première carte de circuit imprimé (5a) de telle sorte que lesdits contacts dépassent d'un bord de la première carte de circuit imprimé avec des branches recourbées vers l'extérieur et les contacts à ressort sont en outre conçus pour maintenir au moins la première carte de circuit imprimé (5a) dans cette position dans l'espace intérieur (3) et pour établir en outre une liaison électrique entre la première carte de circuit imprimé (5a) et le boîtier (2), afin de conduire des courants parasites de la première carte de circuit imprimé (5a) au boîtier (2) via les contacts à ressort (5c).

2. Appareil de terrain selon la revendication 1, pour lequel les contacts à ressort (5c) sont disposés de manière sensiblement symétrique en rotation dans la zone de bordure (5b) sur la première carte de circuit imprimé (5a).

3. Appareil de terrain selon l'une des revendications précédentes,
pour lequel le circuit électronique (5) comprend au moins une autre carte de circuit imprimé (5d), laquelle carte est reliée électriquement à la première carte de circuit imprimé (5a), et
pour lequel la première carte de circuit imprimé (5a) comprend en outre des composants électroniques (5e), lesquels sont conçus pour réaliser des mesures CEM, notamment des mesures de filtrage CEM et/ou des mesures de décharge CEM.

4. Appareil de terrain selon l'une des revendications précédentes, pour lequel la première carte de circuit imprimé (5a) est formée de plusieurs couches (5f-5i), couches parmi lesquelles au moins une couche comprend une couche de cuivre (5g) pour l'essentiel continue, de sorte que la première carte de circuit imprimé (5a) divise l'espace intérieur (3) en une zone CEM blindée (7) et une zone CEM non blindée (8).

5. Appareil de terrain selon l'une des revendications précédentes, lequel appareil comprend en outre une interface d'appareil de terrain (9) intégrée dans le boîtier (2), de préférence un connecteur, de manière particulièrement préférée un connecteur M12 pour la communication de données, l'interface d'appareil de terrain (9) comprenant en outre un contact électrique de mise à la terre (9a), contact par l'intermédiaire duquel la première carte de circuit imprimé (5a) est reliée à l'interface d'appareil de terrain (9) afin d'évacuer les courants parasites.
